(19) Europäisches Patentamt
European Patent Office
Office européen des brevets

(11) **EP 2 955 763 A1**

(12) **EUROPEAN PATENT APPLICATION**
published in accordance with Art. 153(4) EPC

(43) Date of publication:
**16.12.2015 Bulletin 2015/51**

(51) Int Cl.:
*H01L 33/32* (2010.01)          *H01S 5/343* (2006.01)

(21) Application number: **14748637.7**

(86) International application number:
**PCT/JP2014/052474**

(22) Date of filing: **03.02.2014**

(87) International publication number:
**WO 2014/123092 (14.08.2014 Gazette 2014/33)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **05.02.2013 JP 2013020723**
**17.05.2013 JP 2013105182**

(71) Applicant: **Tokuyama Corporation**
**Shunan-shi, Yamaguchi-ken 745-8648 (JP)**

(72) Inventor: **OBATA, Toshiyuki**
**Shunan-shi**
**Yamaguchi 745-8648 (JP)**

(74) Representative: **Beck Greener**
**Fulwood House**
**12 Fulwood Place**
**London WC1V 6HR (GB)**

(54) **NITRIDE SEMICONDUCTOR LIGHT-EMITTING ELEMENT**

(57) A nitride semiconductor deep ultraviolet light emitting device having a superior light emission efficiency is provided. A nitride semiconductor light emitting device having emission wavelength of 200 to 300 nm includes an n-type layer consisting of a single layer or a plurality of layers having different band gaps, a p-type layer consisting of a single layer or a plurality of layers having different band gaps, an active layer arranged between the n-type layer and the p-type layer, and an electron blocking layer having a band gap larger than any band gap of layers composing the active layer and the p-type layer. The p-type layer includes a first p-type layer having a band gap larger than a band gap of a first n-type layer which has a smallest band gap in the n-type layer. The electron blocking layer is arranged between the active layer and the first p-type layer.

FIG. 2

## Description

Technical Field

The present invention relates to a novel deep ultraviolet light emitting device that employs a nitride semiconductor and whose emission wavelength is in the range of 200 to 300 nm.

Background Art

Under present circumstances, gas discharge lamps using heavy hydrogen, mercury, or the like are used as deep ultraviolet light sources whose emission wavelength is 300 nm or less. There are inconveniences of shortlivedness, large size and so on in these gas discharge lamps. In addition, mercury is a substance on which more and more conventions are regulating activities. Thus, the realization of deep ultraviolet light emitting devices employing semiconductors that are possible to overcome these inconvenience and that are easy to be treated is awaited.

However, there are problems with light emitting devices employing semiconductors that light output is lower compared to that from gas discharge lamps such as heavy hydrogen-vapor lamps and mercury-vapor lamps; and the light emission efficiency is also low.

It is a cause of insufficient light output from semiconductor light emitting devices that in nitride semiconductor light emitting devices, the effective mass of electrons is smaller compared to holes, and the carrier density is high; thus, electrons cross over active layers (region), to overflow p-type layers, which results in their low light emission efficiency. Such an overflow of electrons to p-type layers results in a further low light emission efficiency under the condition of high injection currents, and at the same time, heating values are increased. As a result, light output has stopped increasing, and it becomes difficult to obtain light output corresponding to the amount of injected carriers.

The problem of an overflow of electrons to p-type layers in nitride semiconductor light emitting devices is not only with deep ultraviolet light emitting devices whose emission wavelength is 300 nm or less (for example, see Non Patent Literature 1). For example, Patent Literature 1 describes the art of, in a semiconductor light emitting device whose emission wavelength is over 300 nm, forming an electron blocking layer having a band gap larger than that of an active layer, between the active layer and a p-type layer, and whereby preventing the outflow of electrons from the active layer region toward the p-type layer, and improving the light emission efficiency. Non Patent Literature 2 describes that an electron blocking layer as described above is tried to be applied to a deep ultraviolet light emitting device (see Non-Patent Literature 2).

Citation List

Non Patent Literature

Non Patent Literature 1: J.Appl.Phys. 108,033112 (2010)
Non Patent Literature 2: Electorn.Lett. 44,493 (2008)

Patent Literature

Patent Literature 1: JP 2007-88269 A
Patent Literature 2: JP 2010-205767 A
Patent Literature 3: JP H11-298090 A

Summary of Invention

Technical Problem

However, according to the inventor's study, it has been found out that the light emission efficiency is not sufficiently improved only by the arrangement of an electron blocking layer in a nitride semiconductor light emitting device whose emission wavelength is 300 nm or less. The inventor assumes the reason as follows: that is, it is required that a band gap of a p-type layer in a deep ultraviolet light emitting device whose emission wavelength is 300 nm or less is larger than that in a near ultraviolet light emitting device or a visible light emitting device; as a result, the activation rate is more decreased and the effective mass becomes large concerning holes in the p-type layer in the deep ultraviolet light emitting device; thus it is considered that the overflow of electrons is easier to occur.

Therefore, an object of the present invention is to solve the problem as above with nitride semiconductor light emitting devices whose emission wavelength is from 200 to 300 nm, and to provide nitride semiconductor deep ultraviolet light emitting devices of the high light emission efficiency.

Solution to Problem

The inventor has intensively done studies to solve the above problem. Specifically, the inventor has studied the relationship among band gaps of layers in detail. Thus, the inventor has found that it is possible to effectively improve the light emission efficiency of a nitride semiconductor deep ultraviolet light emitting device with the arrangement of an electron blocking layer having a band gap larger than those of layers composing an active layer and a p-type layer, and at least one first p-type layer having a band gap larger than that of a layer which has the smallest band gap in an n-type layer (hereinafter this layer may referred to as "first n-type layer"), and has completed the present invention.

The first aspect of the present invention is:

[1] a nitride semiconductor light emitting device having emission wavelength of 200 to 300 nm, including an n-type layer consisting of a single layer or a plurality of layers having different band gaps, a p-type layer consisting of a single layer or a plurality of layers having different band gaps, an active layer arranged between the n-type layer and the p-type layer, and an electron blocking layer having a band gap larger than any band gap of layers composing the active layer and the p-type layer, wherein the p-type layer includes a first p-type layer having a band gap larger than a band gap of a first n-type layer which has a smallest band gap in the n-type layer, and the electron blocking layer is arranged between the active layer and the first p-type layer
[2] In the first aspect of the present invention, the p-type layer may consist of the plurality of layers having different band gaps.
[3] In the first aspect of the present invention, it is preferable that the active layer includes a well layer and a barrier layer; the p-type layer includes a p-type cladding layer and a p-type contacting layer; the nitride semiconductor light emitting device includes a stacked structure in which the n-type layer, the active layer, the electron blocking layer, the p-type cladding layer, and the p-type contacting layer are stacked in the order mentioned; the barrier layer is represented by a composition formula $Al_aGa_{1-a}N$ ($0.34 \leq a \leq 0.89$); the p-type cladding layer is represented by a composition formula $Al_bGa_{1-b}N$ ($0.44 < b < 1.00$); and a difference (b-a) between the Al composition of the p-type cladding layer and the Al composition of the barrier layer is greater than 0.10 and no more than 0.45.
It is noted that the above p-type cladding layer is preferably the first p-type layer.
[4] In the first aspect of the present invention of the embodiment as the above [3], it is preferable that the well layer is represented by a composition formula $Al_eGa_{1-e}N$ ($0.33 \leq e \leq 0.87$); and a difference (a-e) between the Al composition of the barrier layer and the Al composition of the well layer is no less than 0.02
[5] In the first aspect of the present invention of the embodiments as the above [3] to [4], the well layer preferably has a thickness of 4 to 20 nm.
[6] In the first aspect of the present invention of the embodiments as the above [3] to [5], it is preferable that the electron blocking layer is p-type or i-type; the electron blocking layer is represented by a composition formula $Al_cGa_{1-c}N$ ($0.45 \leq c \leq 1.00$); the p-type cladding layer is represented by a composition formula $Al_bGa_{1-b}N$ ($0.44 < b < 1.00$); the Al composition (c) of the electron blocking layer is greater than the Al composition (b) of the p-type cladding layer; a difference (c-a) between the Al composition of the electron blocking layer and the Al composition of the barrier layer is 0.11 to 0.98; and a difference (b-a) between the Al composition of the p-type cladding layer and the Al composition of the barrier layer is greater than 0.10 and no more than 0.45
[7] The first aspect of the present invention of the embodiments as the above [3] to [6] preferably includes a plurality of the barrier layers; and the plurality of barrier layers includes a first barrier layer contacting the n-type layer, and a second barrier layer contacting the electron blocking layer.
[8] The second aspect of the present invention is a nitride semiconductor wafer including stacked structures of the nitride semiconductor light emitting device according to the first aspect of the present invention.

Advantageous Effects of Invention

According to the present invention, electrons in nitride semiconductor deep ultraviolet light emitting devices whose emission wavelength is 300 nm or less can be prevented from overflowing, and thus it is possible to improve the light emission efficiency of the nitride semiconductor deep ultraviolet light emitting devices.

Brief Description of Drawings

FIG. 1 is a schematic cross-sectional view to explain one embodiment of a nitride semiconductor light emitting device of the present invention.

FIG. 2 is a view to explain one example of an energy band diagram of the nitride semiconductor light emitting device of FIG. 1.

FIG. 3 is a schematic cross-sectional view to explain one example of an energy band diagram according to another embodiment of the nitride semiconductor light emitting device of the present invention.

FIG. 4 is a schematic cross-sectional view to explain one example of the energy band diagram according to the above embodiment of the nitride semiconductor light emitting device of the present invention.

FIG. 5 is a schematic cross-sectional view to explain one example of the energy band diagram according to the above embodiment of the nitride semiconductor light emitting device of the present invention.

FIG. 6 is a schematic cross-sectional view to explain still another embodiment of the nitride semiconductor light emitting device of the present invention.

FIG. 7 is a view to explain one example of an energy band diagram of the nitride semiconductor light emitting device of FIG. 6.

FIG. 8 is a schematic cross-sectional view to explain still another embodiment of the nitride semiconductor light emitting device of the present invention.

FIG. 9 is a view to explain examples of an energy band diagram of the nitride semiconductor light emitting device of FIG. 8.

FIG. 10 is a schematic cross-sectional view to explain still another embodiment of the nitride semiconductor light emitting device of the present invention.

FIG. 11 is a view to explain one example of an energy band diagram of the nitride semiconductor light emitting device of FIG. 10.

FIG. 12 is a schematic cross-sectional view to explain still another embodiment of the nitride semiconductor light emitting device of the present invention.

FIG. 13 is a view to explain examples of an energy band diagram of the nitride semiconductor light emitting device of FIG. 12.

FIG. 14 is a schematic cross-sectional view to explain still another embodiment of the nitride semiconductor light emitting device of the present invention.

FIG. 15 is a view to explain one example of an energy band diagram of the nitride semiconductor light emitting device of FIG. 14.

Description of Embodiments

<1. Nitride Semiconductor Light Emitting Device>

First, the basic summary of a nitride semiconductor light emitting device will be described.

In the present invention, a nitride semiconductor light emitting device having the emission wavelength from 200 to 300 nm (hereinafter may be simply shortened to "deep ultraviolet light emitting device") can be manufactured by, for example, metalorganic chemical vapor deposition (MOCVD). Specifically, the nitride semiconductor light emitting device can be manufactured with an apparatus on the market, by supplying a group III raw material gas, for example, an organo-metallic gas such as trimethylaluminium, and a nitrogen source gas, for example, a raw material gas such as an ammonia gas to the top of a single-crystalline substrate described later or on the top of a substrate of a stack. Conditions of known methods can be employed for those for manufacturing the nitride semiconductor light emitting device by MOCVD. The nitride semiconductor light emitting device of the present invention can be manufactured by a method other than MOCVD as well.

In the present invention, the nitride semiconductor light emitting device is not specifically limited as long as its emission wavelength is from 200 to 300 nm. Specifically, the composition of each layer may be determined from compositions including nitrogen and at least one selected from boron, aluminum, indium and gallium and represented by a general formula: $B_X Al_Y In_Z Ga_{1-x-y-z}N$ ($0 \leq x \leq 1$, $0 < y \leq 1$, $0 \leq z < 1$ and $0 < x+y+z \leq 1$), to compose the nitride semiconductor light emitting device whose emission wavelength is from 200 to 300 nm. More specifically, for example, if an active layer is composed by the composition represented by $Al_a Ga_{1-a}N$, the composition of $0.2 \leq a \leq 1$ is necessary.

Generally, it is likely that the more the proportion of B and/or Al increases, the larger band gaps are, and the more the proportion of In and/or Ga increases, the smaller band gaps are. Thus, the band gap of each layer can be controlled by the proportion of these constituent elements. The proportion of the constituent elements can be obtained by measuring the manufactured nitride semiconductor light emitting device with an SIMS (Secondary Ion-microprobe Mass Spectrometer), by TEM-EDX (Transmission Electron Microscope-Energy Dispersive X-ray spectrometry), by three dimensional atom prove (3DAP) or the like. The proportion of the constituent elements of each layer can be converted into the band gap. The band gap of each layer can be directly obtained by analyzing the nitride semiconductor light emitting device using cathodeluminescence spectroscopy (CL) or photo luminescence (PL) as well. In a case where the constituent elements are Al, Ga and N, the Al-composition can be specified using a conversion formula by the value of the band gap.

In Examples and Comparative Examples of the present invention, the proportion of constituent elements of each layer was measured by X-ray diffraction (XRD), and band gaps were obtained by PL. When the technical scope of the invention disclosed in this application is judged, values measured by XRD shall be employed for the composition of each layer, and values determined by PL shall be employed for the band gap of each layer unless there are specific circumstances.

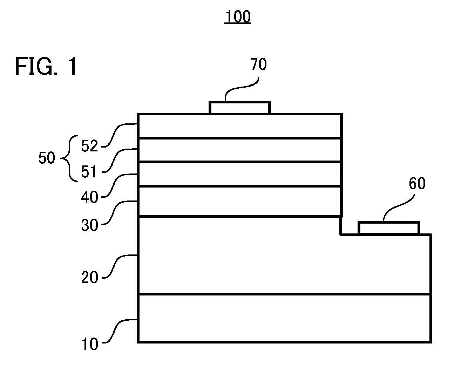

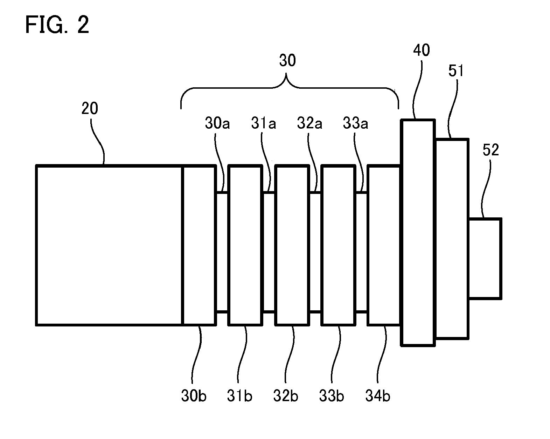

The nitride semiconductor light emitting device according to one aspect of the present invention will be described using drawings in detail. Fig. 1 is a schematic cross-sectional view of the nitride semiconductor light emitting device of the present invention according to one embodiment. Fig. 2 is a view to explain one example of an energy band diagram of the nitride semiconductor light emitting device of FIG. 1. In FIG. 2, the size of each band gap is represented in the vertical direction of the sheet. The energy band diagram is drawn so that an upper part of the drawing represents higher energy of electrons (lower energy of holes). This applies to the other energy band diagrams of the present application as well. For example, in FIG. 2, it is represented that the band gaps of an electron blocking layer 40 and a first p-type layer 51 are larger than that of an n-type layer 20.

As depicted in FIG. 1, a nitride semiconductor light emitting device 100 has a substrate 10, the n-type layer 20 arranged on the substrate 10, an active layer 30 arranged on the n-type layer 20, the electron blocking layer 40 arranged on the active layer 30, and a p-type layer 50 arranged on the electron blocking layer 40. The n-type layer is a single layer in the nitride semiconductor light emitting device 100 of FIG. 1. In this case, the n-type layer 20 corresponds to a first n-type layer having the smallest band gap in the n-type layer. The p-type layer 50 consists of plural layers that have different band gaps in the nitride semiconductor light emitting device 100 of FIG. 1. The p-type layer 50 is composed by a first p-type layer (p-type cladding layer) 51 having a band gap larger than that of the first n-type layer 20, and a second p-type layer (p-type contacting layer) 52 having a band gap different from that of the first p-type layer 51.

The nitride semiconductor light emitting device 100 further includes an electrode for n-type 60 that is arranged on an exposed surface of the n-type layer 20 that is exposed by etching removal of the second p-type layer 52, the first p-type layer 51, the electron blocking layer 40, the active layer 30 and a part of the n-type layer 20, and an electrode for p-type 70 that is arranged on the second p-type layer 52. The electrode for n-type 60 and the electrode for p-type 70 can be formed by a known method. Each layer will be described in detail hereinafter.

(Substrate 10)

A known substrate manufactured by a known method can be employed as the substrate 10 without any specific limitation. Concrete examples of substrates that can be employed as the substrate 10 include an AlN substrate, a GaN substrate, a sapphire substrate, an SiC substrate and an Si substrate. Among them, an AlN substrate where a c-plane is a growth surface, or a sapphire substrate where a c-plane is a growth surface is preferable. The thickness of the substrate 10 is not specifically limited. However, the range of 0.1 mm to 2 mm is preferable.

(n-type Layer 20)

The n-type layer 20 is a layer where an n-type dopant is doped. In the deep ultraviolet light emitting device 100 of FIG. 1, the n-type layer 20 is a single layer, and thus, the n-type layer 20 is same as the first n-type layer having the smallest band gap in the n-type layer. This n-type layer 20 is not specifically limited. For example, however, preferably employed can be an embodiment where the n-type layer 20 includes an Si dopant so that the impurity concentration is from $1\times10^{16}$ to $1\times10^{21}$ $(cm^{-3})$, to exhibit n-type electrical conductive properties. A dopant material may be a material other than Si.

When the n-type layer 20 is a single layer, the band gap of the n-type layer 20 is not specifically limited as long as its band gap is smaller than that of the first p-type layer, which is described below. Though, it is preferable that the value of the band gap of the n-type layer 20 is in the range of 4.15 eV to 6.27eV in order to improve the productivity and to enhance the use of the nitride semiconductor light emitting device whose emission wavelength is from 200 to 300 nm. It is more preferable that its range is from 4.20 eV to 6.25 eV. It is specifically preferable that its range is from 4.50 eV to 5.50 eV.

Examples of preferable composition of the n-type layer 20 include the composition where Al composition (d) is 0.34 to 1.00 when the n-type layer 20 is represented by the composition formula, $Al_dGa_{1-d}N$. When the n-type layer 20 is represented by the composition formula, $Al_dGa_{1-d}N$, the Al composition (d) is more preferably from 0.34 to 0.90; further preferably from 0.34 to 0.80; and most preferably from 0.45 to 0.70. It is also preferable that the n-type layer 20 is composed by a single crystal.

The film thickness of the n-type layer 20 is not specifically limited. It can be in the range of 1 nm to 50 $\mu$m.

While the n-type layer 20 included in the nitride semiconductor light emitting device 100 of FIG. 1 is a single layer, it is also preferable that in an embodiment of including the n-type layer consisting of a plurality of layers having different band gaps (described later), all the plurality of layers composing the n-type layer have the above preferable or typical composition.

(Active Layer 30)

The active layer 30 has a quantum well structure including at least one well layer and at least one barrier layer (hereinafter may simply referred to as "quantum well structure"). In the energy band diagram of FIG. 2, the active layer 30 has a quantum well structure including well layers 30a, 31a, 32a and 33a, and barrier layers 30b, 31b, 32b, 33b and 34b.

Band gaps of layers composing the active layer are not specifically limited as long as those are smaller than that of the electron blocking layer. When the active layer has the quantum well structure including at least one well layer and at least one barrier layer, generally, the barrier layer has a band gap larger than the well layer in the active layer. Thus, in a case where the band gap of a barrier layer that has the largest band gap in the active layer is smaller than that of the electron blocking layer, the band gaps of layers comprising the active layer are not limited. The band gaps of the well layers can be properly determined depending on other layers, and the range of 4.13 eV to 6.00 eV is preferable, the range of 4.18 eV to 5.98 eV is more preferable, and the range of 4.20 eV to 5.00 eV is further preferable. The band gaps of the barrier layers are not specifically limited as well, and the range of 4.15 eV to 6.02 eV is preferable, the range of 4.20 eV to 6.00 eV is more preferable, and the range of 4.30 eV to 5.50 eV is specifically preferable.

It is preferable that the thickness of each well layer and barrier layer is from 1 to 50 nm.

(Barrier Layers 30b, 31b, 32b, 33b and 34b)

Each barrier layer may be composed by a single crystal having the composition represented by the composition formula, $Al_aGa_{1-a}N$ ($0.34 \leq a \leq 1.00$), and preferably, is composed by a single crystal having the composition represented by the composition formula, $Al_aGa_{1-a}N$ ($0.34 \leq a \leq 0.89$). As described later, in a case where the first p-type layer (p-type cladding layer) 51 is formed by a single crystal represented by the composition formula $Al_bGa_{1-b}N$ ($0.44 < b < 1.00$), it is preferable that difference between the Al composition of the first p-type layer (p-type cladding layer) 51 and that of each barrier layer (b-a) is greater than 0.10 and no more than 0.45. In this case, in view of improving the productivity and also further improving the light emission efficiency, it is more preferable that the Al composition of each barrier layer (a) is $0.34 \leq a \leq 0.80$ and the difference in Al composition (b-a) is no less than 0.12 and no more than 0.45; and it is specifically preferable that the Al composition of each barrier layer (a) is $0.40 \leq a \leq 0.70$ and the difference in Al composition (b-a) is no less than 0.12 and no more than 0.45.

In a case where a plurality of the barrier layers are included in the active layer like the barrier layers 30b, 31b, 32b, 33b and 34b in FIG. 2, the thickness and composition of each barrier layer may be either the same or different. It is preferable that every barrier layer has the thickness in the range of 2 to 50 nm. It is also preferable that the composition of every barrier layer can be represented by the above composition formula ($0.34 \leq a \leq 0.89$). In a case where the composition is different between a plurality of the barrier layers, if the Al composition of the barrier layers is compared with that of layers other than the barrier layers, such comparison shall be carried out based on a barrier layer of the highest Al composition (a) (for example, b-a is evaluated). In view of the productivity, it is preferable that a plurality of the barrier layers have the same thickness and the same composition. The thickness of each barrier layer is more preferably from 2 to 20 nm, and further preferably from 2 to 10 nm.

(Well Layers 30a, 31a, 32a and 33a)

It is preferable that each well layer is composed by a single crystal having the composition represented by the composition formula, $Al_eGa_{1-e}N$ ($0.33 \leq e \leq 0.87$). Each well layer is composed so as to have a band gap smaller than the barrier layers. Thus, in a case where each of the well layers and the barrier layers is composed by a single crystal of AlGaN, each well layer is composed by a single crystal of AlGaN having the Al composition lower than that of each barrier layer.

In a case where each well layer is composed by a single crystal represented by the composition formula, $Al_eGa_{1-e}N$ and each barrier layer is composed by a single crystal represented by the composition formula, $Al_aGa_{1-a}N$, it is preferable that difference between the Al composition of each barrier layer (a) and that of each well layer (e) (a-e) is no less than 0.02. The upper limit of the difference (a-e) is not specifically determined. However, the difference (a-e) is preferably no more than 0.87.

An absolute value of the Al composition of each well layer (e) when each well layer is composed by a single crystal represented by the composition formula, $Al_eGa_{1-e}N$ may be determined depending on band gaps of other layers. This absolute value has only to satisfy the composition formula $Al_eGa_{1-e}N$ ($0.33 \leq e \leq 1.00$), preferably satisfies the composition formula $Al_eGa_{1-e}N$ ($0.33 \leq e \leq 0.87$), more preferably satisfies the composition formula, $Al_eGa_{1-e}N$ ($0.33 \leq e \leq 0.78$), and specifically preferably satisfies the composition formula, $Al_eGa_{1-e}N$ ($0.33 \leq e \leq 0.68$).

The thickness of each well layer is preferably from 4 nm to 20 nm. When the difference between the Al composition of the p-type cladding layer and that of each barrier layer (a-e) is within the above preferable range, the light emission efficiency is more improved by the thickness of each well layer being from 4 nm to 20 nm. The efficiency of hole injection is improved by a comparatively thick well layer, that is, no less than 4 nm, which makes it possible to reduce the overflow of carriers in a high current injection region. On the other hand, while internal fields in the active layer functions as spatially decoupling wave functions of electrons and holes that are confined in the well layer from each other, to make the efficiency of the recombination low, the internal fields can be screened enough by injected carriers because the thickness of each well layer is no more than 20 nm. Thus, it is possible to suppress spatial decoupling between the wave function of electrons and that of holes, to improve the probability of the recombination. In more detail, not a rectangular potential but a triangular potential is formed on a heterointerface, where the composition is different, of the nitride semiconductor, specifically the nitride semiconductor light emitting device represented by AlGaN because of the effect of spontaneous polarization. Therefore, in a case where a quantum well layer is composed, injected electrons and holes are unevenly distributed to opposite interfaces to each other because of the quantum confined stark effect (hereinafter simply referred to as "QCSE") due to the internal fields, and thus are spatially decoupled. As a result, the probability of the recombination of electrons and holes are decreased, and therefore, the internal quantum efficiency is decreased. On the contrary, since the internal fields can be screened enough by injected carriers because the thickness of each well layer is no more than 20 nm, QCSE can be suppressed. In view of the same, the thickness of each well layer is preferably from 4 nm to 18 nm, and more preferably, from 4 nm to 15 nm.

In a case where a plurality of the well layers are included in the active layer like the well layers 30a, 31a, 32a and 33a in FIG. 2, the thickness and composition of each well layer may be either the same or different. It is preferable that every well layer has the thickness in the range of 4 nm to 20 nm. It is also preferable that every well layer is composed by a single crystal that can be represented by the composition formula, $Al_eGa_{1-e}N$ ($0.33 \leq e \leq 0.87$). It is also preferable that difference between the Al composition of each barrier layer (a) and that of each well layer (e) (a-e) is no less than 0.02. In view of the productivity, it is preferable that a plurality of the well layers have the same thickness and the same composition.

(Structure of Active Layer 30)

As depicted in FIG. 2, the active layer 30 has a structure of including a plurality of the barrier layers, which include one barrier layer 30b that contacts the n-type layer 20, and another barrier layer 34b that contacts the electron blocking layer 40. The active layer 30 having such a structure makes it possible to prevent dopants from diffusing from the n-type layer 20 and the p-type layers 51 and 52 to the well layers 30a, 31a, 32a and 33a.

Either a p-type or an n-type dopant may be doped into the barrier layers 30b to 34b. In a case where a p-type dopant is doped into the barrier layers 30b to 34b, the effect of suppressing the overflow of carriers and the effect of decreasing QCSE can be improved. In a case where an n-type dopant is doped into the barrier layers 30b to 34b, the effect of decreasing QCSE can be improved.

(Electron Blocking Layer 40)

The electron blocking layer 40 is a layer for suppressing leakage of part of electrons that are injected from the n-type layer to the active layer by applying an electric field, into the p-type layer side. Therefore, it is necessary for the electron blocking layer 40 to have a band gap larger than those of any layers that compose the active layer 30 and the p-type layer 50, which is described later. It is also necessary for the electron blocking layer 40 to be formed between the active layer 30 and the first p-type layer (p-type cladding layer) 51, which is described later.

The band gap of the electron blocking layer 40 is larger than those of any layers constituting the active layer 30, and also larger than those of any layers constituting the p-type layer 50.

The band gap of the electron blocking layer 40 is not specifically limited as long as being larger than those of any layers constituting the active layer 30 and the p-type layer 50. The band gap of the electron blocking layer 40 is preferably larger than that of a barrier layer having the largest band gap in the active layer 30 by no less than 0.03 eV, more preferably by no less than 0.05 eV, and specifically preferably by no less than 0.20 eV. The upper limit of the difference between the band gap of the electron blocking layer 40 and the largest band gap of the active layer 30 is not specifically determined. In view of the productivity, no less than 2.15 eV is preferable. It is preferable that the band gap of the electron blocking layer 40 is larger than that of a layer having the largest band gap in layers constituting the p-type layer 50 (first p-type layer (p-type cladding)51) by no less than 0.02 eV, more preferably no less than 0.04 eV, and specifically preferably no less than 0.10 eV. The upper limit of the difference between the band gap of the electron blocking layer 40 and the largest band gap in the layers constituting the p-type layer 50 is not specifically determined. In view of the productivity, the difference is preferably no more than 2.14 eV, more preferably no more than 2.09 eV, and specifically preferably no more than 1.20 eV.

An absolute value of the band gap of the electron blocking layer 40 is not specifically limited. However, the absolute value is preferably no less than 4.18 eV and no more than 6.30 eV, more preferably no less than 4.25 eV and no more than 6.30 eV, and specifically preferably no less than 4.70 eV and no more than 6.30 eV.

It is preferable that the electron blocking layer 40 is composed by a single crystal of AlGaN. In a case where each of the active layer 30, the p-type layer 50 and the electron blocking layer 40 are composed by a single crystal of AlGaN, it is preferable that the electron blocking layer 40 is composed by a single crystal of AlGaN whose Al composition proportion is higher than any other layers constituting the active layer 30 and the p-type layer 50. In a case where the n-type layer 20 is composed by a single crystal of AlGaN, it is preferable that the electron blocking layer 40 is composed by a single crystal of AlGaN whose Al composition is higher than that of the n-type layer 20, while the electron blocking layer 40 may be composed by a single crystal of AlGaN whose Al composition is lower than that of the n-type layer 20. That is, it is preferable that the electron blocking layer 40 is composed by a single crystal of AlGaN whose Al composition is higher than any other layers.

When the electron blocking layer 40 is represented by the composition formula, $Al_cGa_{1-c}N$, the Al composition of the electron blocking layer 40 (c) is preferably $0.45 \leq c \leq 1.00$, and specifically preferably, $0.53 \leq c \leq 1.00$. In view of further improving the effect of the present invention, it is preferable that difference between the Al composition of the electron blocking layer 40 (c) and that of each barrier layer (a) (c-a) is from 0.11 to 0.98, more preferably from 0.13 to 0.80, and further preferably from 0.13 to 0.60.

As described below, in a case where the first p-type layer (p-type cladding layer) 51 is composed by a single crystal represented by the composition formula, $Al_bGa_{1-b}N$ (0.44 < b < 1.00), it is preferable that the Al composition of the electron blocking layer 40 (c) is higher than that of the first p-type layer (p-type cladding layer) 51 (b). Specifically, it is preferable that difference between the electron blocking layer 40 and the first p-type layer (p-type cladding layer) 51 in Al composition (c-b) is greater than 0.00 and no more than 0.88, more preferably, greater than 0.00 and no more than 0.80, and further preferably no less than 0.01 and no more than 0.70.

A p-type dopant may be doped into the electron blocking layer 40, or the electron blocking layer 40 may be an undoped layer. In a case where a p-type dopant, for example, Mg is doped into the electron blocking layer 40, the impurity concentration is preferably from $1\times10^{16}$ to $1\times10^{21}$ (cm$^{-3}$). Furthermore, both an area where a p-type dopant is doped and an undoped area may exist in the electron blocking layer 40. If the electron blocking layer has both the doped area and the undoped area, the impurity concentration of whole of the electron blocking layer 40 is preferably from $1\times10^{16}$ to $1\times10^{21}$ (cm$^{-3}$).

The thickness of the electron blocking layer 40 is not specifically limited. It is preferably from 1 nm to 50 nm.

(p-type Layer 50)

The nitride semiconductor light emitting device 100 has, in the p-type layer 50, the first p-type layer (p-type cladding layer) 51 whose band gap is larger than that of the first n-type layer (20), which has the smallest band gap in the n-type layer 20, together with the electron blocking layer 40.

In the nitride semiconductor light emitting device 100 of FIG. 1, the p-type layer 50 consists of the first p-type layer (p-type cladding layer) 51 and the second p-type layer (p-type contacting layer) 52 that contacts the electrode for p-type 70. A p-type dopant is doped into the p-type layer 50, and the p-type layer 50 exhibits p-type electrical conductive properties. Specifically, the p-type layer 50 preferably includes Mg as a p-type dopant so that the impurity concentration is from $1\times10^{16}$ to $1\times10^{21}$ (cm$^{-3}$). In the p-type layer 50, impurities may be distributed evenly, or the impurity concentration may be unevenly distributed. Moreover, in a case where the p-type layer 50 consists of a plurality of layers as is in FIG. 1, the impurity concentration of the plurality of layers may be either the same or different.

(First p-type Layer (p-type Cladding Layer) 51)

Arranged in the nitride semiconductor light emitting device 100 are the first p-type layer (p-type cladding layer) 51 having a band gap larger than that of the first n-type layer (n-type layer 20 in FIGS. 1 and 2) having the smallest band gap in the n-type layer. Also, the electron blocking layer 40 is arranged between the first p-type layer (p-type cladding layer) and the active layer 30. While the electron blocking layer 40 functions as a potential barrier against electrons that tend to flow from the active layer 30 toward the p-type layer 50, the existence of this first p-type layer (p-type cladding layer) 51 makes it possible to suppress penetration of the wave function of electrons from the active layer 30 to the p-type layer 50 side of the electron blocking layer 40. Thus, it can be more effectively reduced that the electrons flow out of the active layer 30 to the p-type layer 50.

Difference between the n-type layer 20 (first n-type layer) and the first p-type layer (p-type cladding layer) 51 in band gap is not specifically limited. The first p-type layer (p-type cladding layer) has preferably a band gap larger than that of the first n-type layer 20 by no less than 0.01 eV, and more preferably, by no less than 0.10 eV. The upper limit of the difference between the n-type layer 20 (first n-type layer) and the first p-type layer (p-type cladding layer) 51 in band gap is not specifically limited. In view of the productivity, this difference is preferably no more than 1.50e V, more preferably, no more than 1.00 eV, and specifically preferably, no more than 0.50 eV.

An absolute value of the band gap of the first p-type layer 51 is not specifically limited as long as being larger than that of the first n-type layer 20. However, this absolute value is preferably no less than 4.16 eV and no more than 6.28, more preferably no less than 4.21 eV and no more than 6.26 eV, and specifically preferably no less than 4.60 eV and no more than 5.60 eV.

It is preferable that the first p-type layer (p-type cladding layer) 51 is composed by a single crystal represented by the composition formula, $Al_bGa_{1-b}N$ ($0.44 < b < 1.00$). Its Al composition (b) is preferably no less than 0.52 and no more than 0.99. It is preferable that the difference between the Al composition of the first p-type layer (p-type cladding layer) (b) and that of each barrier layer (b-a) is greater than 0.10 and no more than 0.45, and more preferably, no less than 0.12 and no more than 0.45 as described above.

The thickness of the first p-type layer (p-type cladding layer) 51 is not specifically limited. It is preferably from 1 nm to 1 $\mu$m.

(Second p-type Layer (p-type Contacting Layer) 52)

In the present invention, the p-type layer 50 may be a single layer (in this case, the p-type layer 50 is the first p-type layer (p-type cladding layer)). However, composition of the second p-type layer (p-type contacting layer) 52 makes it easy to realize ohmic contact with the electrode for p-type 70, and to reduce the contact resistance against the electrode for p-type 70.

The second p-type layer (p-type contacting layer) 52 has a band gap smaller than that of the first p-type layer (p-type cladding layer) 51. Specifically, it is preferable that the band gap of the second p-type layer (p-type contacting layer) 52 takes a smaller value than that of the first p-type layer (p-type cladding layer) 51; and its absolute value is preferably no less than 0.70 eV and no more than 6.00 eV, and more preferably the absolute value is no less than 3.00 eV and no more than 4.50 eV. Typical examples include an embodiment of the second p-type layer (p-type contacting layer) 52 composed by GaN (band gap: 3.4 eV).

The second p-type layer (p-type contacting layer) 52 is preferably composed by a single crystal of AlGaN. In a case where each first p-type layer (p-type cladding layer) 51 and second p-type layer (p-type contacting layer) 52 is composed by a single crystal of AlGaN, the second p-type layer (p-type contacting layer) 52 is preferably lower than the first p-type layer (p-type cladding layer) 51 in Al composition. In a case where the second p-type layer (p-type contacting layer) 52 is composed by a single crystal represented by the composition formula, $Al_fGa_{1-f}N$, its Al composition (f) may be from 0.00 to 1.00, preferably from 0.00 to 0.70, and more preferably from 0.00 to 0.40. When the second p-type layer (p-type contacting layer) 52 is composed by GaN as the above typical example, f = 0.00. The second p-type layer (p-type contacting layer) 52 may include In as long as any effect of the present invention is not blocked.

The thickness of the second p-type layer (p-type cladding layer) 52 is preferably from 1 nm to 250 nm.

(Other Embodiments (1): Other Structures of Active Layer)

While mainly given as an example in the above description concerning the present invention is the nitride semiconductor light emitting device 100 wherein the active layer 30 has a quantum well structure and four well layers are included therein, the present invention is not limited to this embodiment. When the active layer has a quantum well structure in the nitride semiconductor light emitting device of the present invention, the number of the well layers may be either one or plural. While the upper limit of the number of the well layers is not specifically limited, preferably no more than 10 in view of the productivity of the nitride semiconductor light emitting device. The nitride semiconductor light emitting device can take such an embodiment that the active layer therein does not have a quantum well structure but has a bulk structure (double heterostructure). In a case where the active layer 30 has a bulk structure, the thickness of the active layer 30 is preferably from 20 to 100 nm.

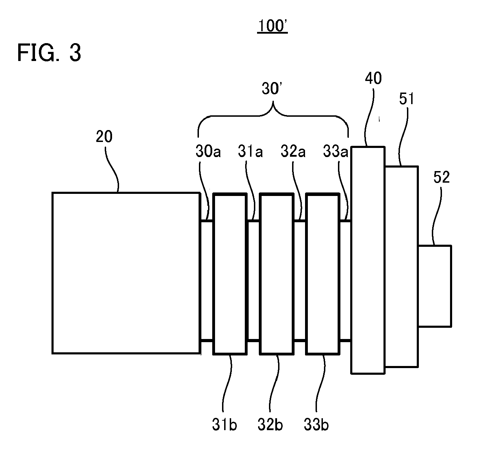

While mainly given as an example in the above description concerning the present invention is the nitride semiconductor light emitting device 100 wherein the active layer 30 has the quantum well structure including the well layers 30a to 33a and the barrier layers 30b to 34b; a layer contacting the n-type layer 20 is the barrier layer 30b; and a layer contacting the electron blocking layer 40 is the barrier layer 34b, the present invention is not limited to this embodiment. The nitride semiconductor light emitting device can take such an embodiment as to have a first well layer that contacts the n-type layer and a second well layer that contacts the electron blocking layer. FIG. 3 is a view to explain an energy band diagram of a nitride semiconductor light emitting device 100' of the present invention according to such another embodiment. In FIG. 3, the same elements as FIGS. 1 to 2 are denoted by the same reference numerals as those in FIGS. 1 to 2, and description thereof is omitted. As depicted in FIG. 3, in the nitride semiconductor light emitting device 100', an active layer 30' includes the well layers 30a, 31a, 32a and 33a and the barrier layers 31b, 32b and 33b. A layer contacting the n-type layer 20 is the well layer 30a and a layer contacting the electron blocking layer 40 is the well layer 33a. In such a stacked structure, the electron blocking layer 40 functions as a barrier layer to the well layer 33a. Thus, overflow of carriers can be suppressed by such a stacked structure.

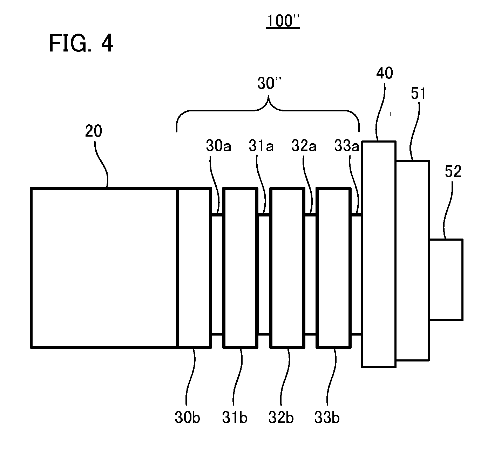

The nitride semiconductor light emitting device can take such an embodiment that a layer contacting the n-type layer is a barrier layer and a layer contacting the electron blocking layer is a well layer. FIG. 4 is a view to explain an energy band diagram of a nitride semiconductor light emitting device 100" of the present invention according to such another embodiment. In FIG. 4, the same elements as FIGS. 1 to 3 are denoted by the same reference numerals as those in FIGS. 1 to 3, and description thereof is omitted. As depicted in FIG. 4, in a nitride semiconductor light emitting device 100", an active layer 30" includes the well layers 30a, 31a, 32a and 33a and the barrier layers 30b, 31b, 32b and 33b. A layer contacting the n-type layer 20 is the barrier layer 30b and a layer contacting the electron blocking layer 40 is the well layer 33a.

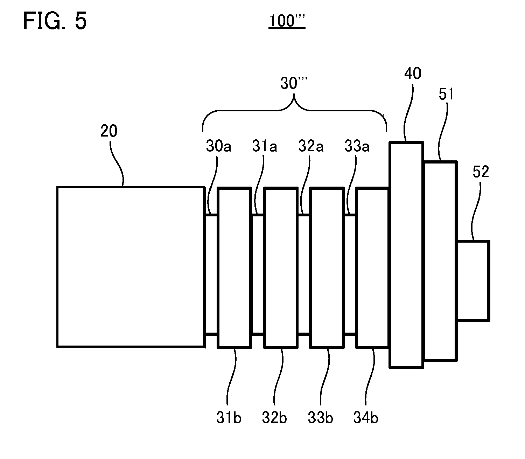

The nitride semiconductor light emitting device can take such an embodiment that a layer contacting the n-type layer is a well layer and a layer contacting the electron blocking layer is a barrier layer. FIG. 5 is a view to explain an energy band diagram of a nitride semiconductor light emitting device 100''' of the present invention according to such another embodiment. In FIG. 5, the same elements as FIGS. 1 to 4 are denoted by the same reference numerals as those in FIGS. 1 to 4, and description thereof is omitted. As depicted in FIG. 5, in the nitride semiconductor light emitting device 100''', an active layer 30''' includes the well layers 30a, 31a, 32a and 33a and the barrier layers 31b, 32b, 33b and 34b. A layer contacting the n-type layer 20 is the well layer 30a and a layer contacting the electron blocking layer 40 is the barrier layer 34b. Such structures (100" and 100''') make it possible to adjust an optical field, and to facilitate the design when semiconductor lasers are manufactured.

(Other Embodiments (2): Embodiment of Having Third p-type Layer)

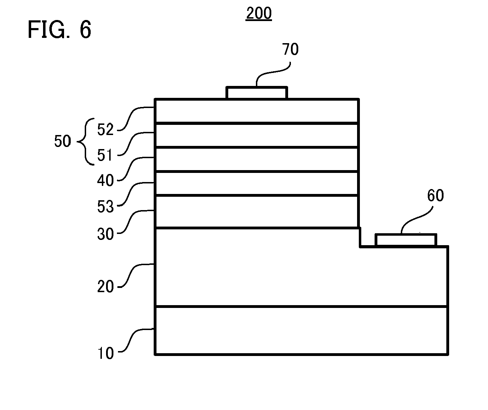

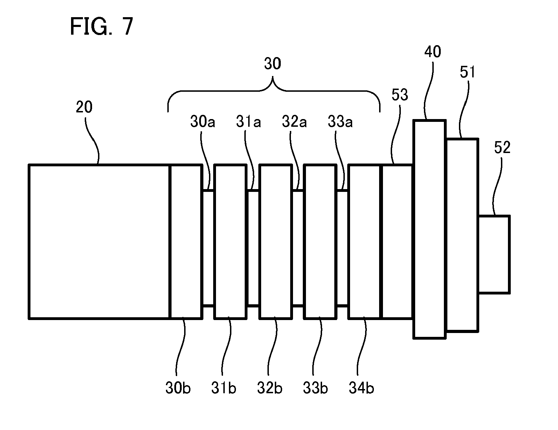

While mainly given as an example in the above description concerning the nitride semiconductor light emitting device of the present invention is the nitride semiconductor light emitting device 100 wherein the active layer 30 and the electron blocking layer 40 are in contact with each other directly, the present invention is not limited to this embodiment. The nitride semiconductor light emitting device can take such an embodiment that a third p-type layer is arranged between the active layer and the electron blocking layer. FIG. 6 is a schematic cross-sectional view of a nitride semiconductor light emitting device 200 according to such another embodiment. FIG. 7 is a view to explain one example of an energy band diagram of the nitride semiconductor light emitting device 200 of FIG. 6. In FIGS. 6 and 7, the same elements as FIGS. 1 to 5 are denoted by the same reference numerals as those in FIGS. 1 to 5, and description thereof is omitted. As depicted in FIG. 6, in the nitride semiconductor light emitting device 200, a third p-type layer 53 is arranged between the active layer 30 and the electron blocking layer 40, which is different from the nitride semiconductor light emitting device 100 of FIG. 1.

Arrangement of the third p-type layer 53 makes it possible to suppress impurities (dopants) from diffusing from the other p-type layers (first p-type layer (p-type cladding layer) 51 and second p-type layer (p-type contacting layer) 52) to the active layer 30, specifically to the well layer 33a, which is the nearest well layer to the p-type layer. Thus, the quality of the active layer 30 can be improved.

The third p-type layer 53 may be either a layer into which a p-type dopant is doped when composed as well as the other p-type layers, or such a layer that: after an undoped layer is once composed, this undoped layer gets the p-type conductivity by diffusion of dopants of other p-type layers. This third p-type layer 53 is composed over the active layer 30, and the electron blocking layer 40 is composed thereover.

It is preferable that the band gap of the third p-type layer 53 is the same as that of the active layer 30, specifically those of the barrier layers 30b to 34d. The thickness of the third p-type layer 53 is preferably no less than 1 nm and no more than 50 nm.

(Other Embodiments (3): Embodiment where n-type Layer Consists of Plural Layers)

While mainly given as an example in the above description concerning the present invention is the nitride semiconductor light emitting devices 100 and 200 wherein the n-type layer is a single layer, that is, the n-type layer 20 is the first n-type layer having the smallest band gap in the n-type layer, the present invention is not limited to this embodiment. The nitride semiconductor light emitting device can take an embodiment of having the n-type layer that consists of plural layers. The nitride semiconductor light emitting device of the present invention according to such other embodiments will be described below.

(Other Embodiments (3-1): Embodiment of Having n-type Underlayer and n-type Cladding Layer)

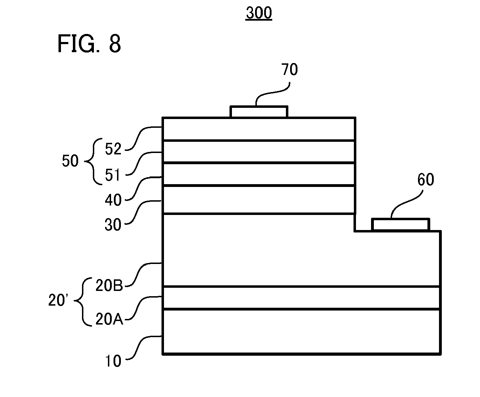

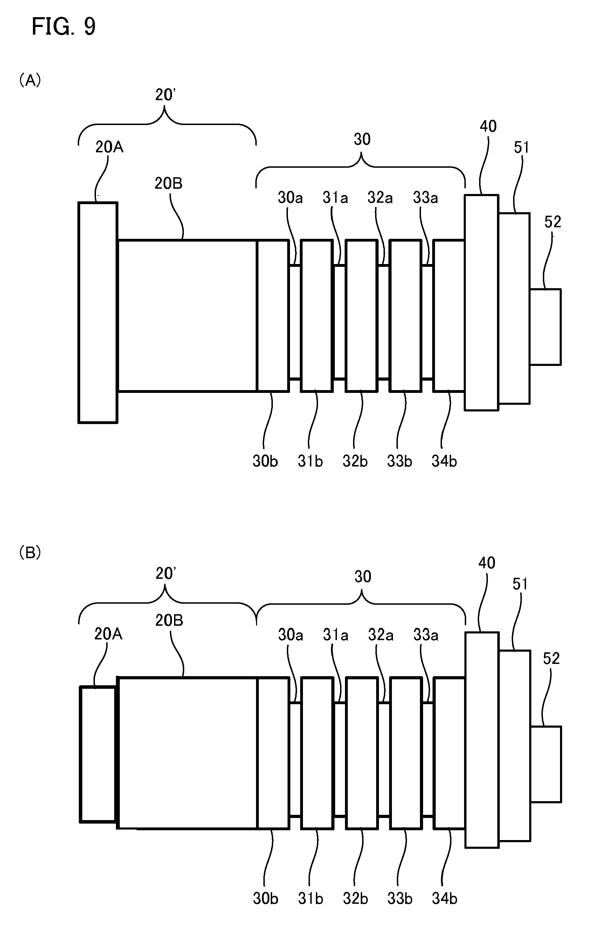

FIG. 8 is a schematic cross-sectional view of a nitride semiconductor light emitting device 300 of the present invention according to another embodiment. FIGS. 9(A) and (B) are views to explain examples of energy band diagrams of the nitride semiconductor light emitting device 300 of FIG. 8. In FIGS. 8 and 9, the same elements as depicted in FIGS. 1 to 7 already are denoted by the same reference numerals as those in FIGS. 1 to 7, and description thereof is omitted. As depicted in FIG. 8, the nitride semiconductor light emitting device 300 has an n-type layer 20' that consists of two layers of an n-type underlayer 20A and an n-type cladding layer 20B, instead of the n-type layer 20, which is a single layer. This is different from the nitride semiconductor light emitting devices 100 and 200 of FIGS. 1 and 6. As depicted in FIG. 8, the n-type cladding layer 20B is arranged between the n-type underlayer 20A and the active layer 30.

The n-type underlayer 20A is a layer for easing lattice mismatch, interface roughening, and the like between the substrate 10 and growth layers (in FIG. 8, the n-type cladding layer 20B and the layers above the n-type cladding layer 20B in the sheet). While the underlayer may be an undoped layer, it is preferable that the underlayer is a layer having the n-type conductivity like this n-type underlayer 20A. Advantages of the n-type underlayer include such that: drive voltage can be decreased in flip chip light emitting devices that require current injection in the horizontal direction.

The n-type cladding layer 20B is a layer that plays the same role as the n-type layer in the embodiment where the n-type layer is a single layer (for example, the n-type layers 20 in the nitride semiconductor light emitting devices 100 and 200 as above), and is a layer for supplying electrons to the active layer 30 along with the n-type underlayer 20A.

These n-type underlayer 20A and n-type cladding layer 20B preferably include Si as a dopant so that the impurity concentration is from $1\times10^{16}$ to $1\times10^{21}$ (cm$^{-3}$), in order to be made to be n-type layers. These impurities (dopant) may be distributed among the n-type underlayer 20A and the n-type cladding layer 20B either homogeneously or unhomogeneously. Part of the side of the n-type underlayer 20A, which contacts the substrate 10, may be undoped.

It is not specifically limited but, for example, in a case where the substrate 10 is a sapphire substrate or on an AlN substrate, as depicted in FIG. 9(A), the band gap of the n-type underlayer 20A is preferably larger than that of the n-type cladding layer 20B. A layer having the smallest band gap in the n-type layer 20', that is, the first n-type layer is preferably the n-type cladding layer 20B. Also, for example, in a case where the substrate 10 is a GaN substrate, as depicted in FIG. 9(B), the band gap of the n-type underlayer 20A is preferably smaller than that of the n-type cladding layer 20B. A layer having the smallest band gap in the n-type layer 20', that is, the first n-type layer is preferably the n-type cladding layer 20A. It is possible to allow the n-type underlayer 20A to function as the n-type cladding layer by making the relationship between the band gap of the n-type underlayer 20A and that of the n-type cladding layer 20B as above according to the material of the substrate 10.

It is also not specifically limited but, for example, in a case where the band gap of the n-type underlayer 20A is larger than that of the n-type cladding layer 20B (see FIG. 9(A)), difference between the n-type underlayer 20A and the n-type cladding layer 20B in band gap is preferably no less than 0.025 eV and no more than 2.00 eV. On the other hand, in a case where the band gap of the n-type underlayer 20A is smaller than that of the n-type cladding layer 20B (see FIG. 9(B)), difference between the n-type underlayer 20A and the n-type cladding layer 20B in band gap is preferably no less than 0.025 eV and no more than 2.00 eV. An absolute value of the band gap of the n-type underlayer 20A is preferably no less than 3.4 eV and no more than 6.30 eV. An absolute value of the band gap of the n-type cladding layer 20B is preferably no less than 4.15 eV and no more than 6.27 eV. The preferable ranges of the absolute values of the band gaps of these n-type underlayer 20A and n-type cladding layer 20B are same as is in the case where other n-type layers are further composed.

The thickness of the n-type underlayer 20A is preferably no less than 1 nm and no more than 50 $\mu$m. The thickness of the n-type cladding layer 20B is preferably no less than 1 nm and no more than 50 $\mu$m.

While in the above description, given as an example is the nitride semiconductor light emitting device 300 that has the embodiment of having the first p-type layer (p-type cladding layer) 51 and the second p-type layer (p-type contacting layer) 52, the present invention is not limited to this embodiment. The nitride semiconductor light emitting device can take such an embodiment that the third p-type layer is further arranged between the active layer and the electron blocking layer like the nitride semiconductor light emitting device 200, which is given as an example already.

(Other Embodiments (3-2): Embodiment of Having n-type Cladding Layer and n-type Hole Blocking Layer)

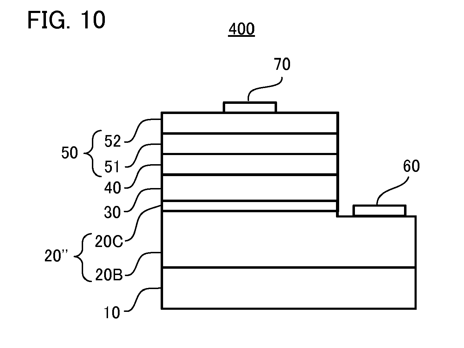

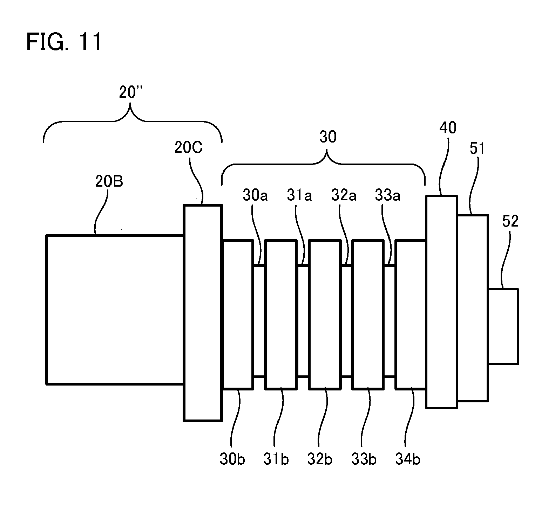

FIG. 10 is a schematic cross-sectional view of a nitride semiconductor light emitting device 400 of the present invention according to another embodiment. Fig. 11 is a view to explain one example of an energy band diagram of the nitride semiconductor light emitting device 400 of FIG. 10. In FIGS. 10 and 11, the same elements as FIGS. 1 to 9 are denoted by the same reference numerals as those in FIGS. 1 to 9, and description thereof is omitted. As depicted in FIG. 10, the nitride semiconductor light emitting device 400 has a n-type layer 20" that consists of two layers of the n-type cladding layer 20B and an n-type hole blocking layer 20C, instead of a single layer of the n-type layer 20, which is different from the nitride semiconductor light emitting devices 100 and 200 in FIGS. 1 and 6. As depicted in FIG. 10, the n-type hole blocking layer 20C is arranged between the n-type cladding layer 20B and the active layer 30.

The n-type hole blocking layer 20C is a layer for suppressing a part of holes that are injected from the p-type layer into the active layer due to application of an electric field from leaking into the n-type layer side. The n-type cladding layer 20B is a layer that plays the function same as the n-type layer in the embodiment of the n-type layer of a single layer (for example, the n-type layers 20 in the above nitride semiconductor light emitting devices 100 and 200), and is a layer for supplying electrons to the active layer 30. It is preferable that these n-type cladding layer 20B and n-type hole blocking layer 20C include, for example, Si as a dopant so that the impurity concentration is from $1\times10^{16}$ to $1\times10^{21}$ $(cm^{-3})$, in order to be made to be n-type layers. These impurities may be distributed among the n-type cladding layer 20B and the n-type hole blocking layer 20C either homogeneously or unhomogeneously.

It is not specifically limited but as depicted in FIG. 11, the band gap of the n-type hole blocking layer 20C is preferably larger than that of the n-type cladding layer 20B. It is also preferable that a layer of the smallest band gap in the n-type layer 20", that is, the first n-type layer is the n-type cladding layer 20B. Moreover, difference between the n-type cladding layer 20B and the n-type hole blocking layer 20C in band gap is preferably no less than 0.025 eV and no more than 2.00 eV. An absolute value of the band gap of the n-type cladding layer 20B is preferably no less than 4.15 eV and no more than 6.27 eV. An absolute value of the band gap of the n-type hole blocking layer 20C is preferably no less than 4.18 eV and no more than 6.29 eV. The preferable ranges of the absolute values of the band gaps of these n-type cladding layer 20B and n-type hole blocking layer 20C are same as is in the case where other n-type layers are further composed.

The thickness of the n-type cladding layer 20B is preferably no less than 1 nm and no more than 50 $\mu$m. The thickness of the n-type hole blocking layer 20C is preferably no less than 1 nm and no more than 1 $\mu$m.

While in the above description, given as an example is the nitride semiconductor light emitting device 400 that has the embodiment of including the first p-type layer (p-type cladding layer) 51 and the second p-type layer (p-type contacting layer) 52, the present invention is not limited to this embodiment. The nitride semiconductor light emitting device can take such an embodiment of further arranging the third p-type layer between the active layer and the electron blocking layer.

(Other Embodiments (3-3): Embodiment of Having n-type Cladding Layer and n-type Current Spreading Layer)

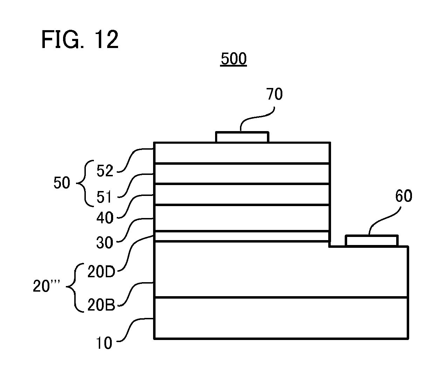

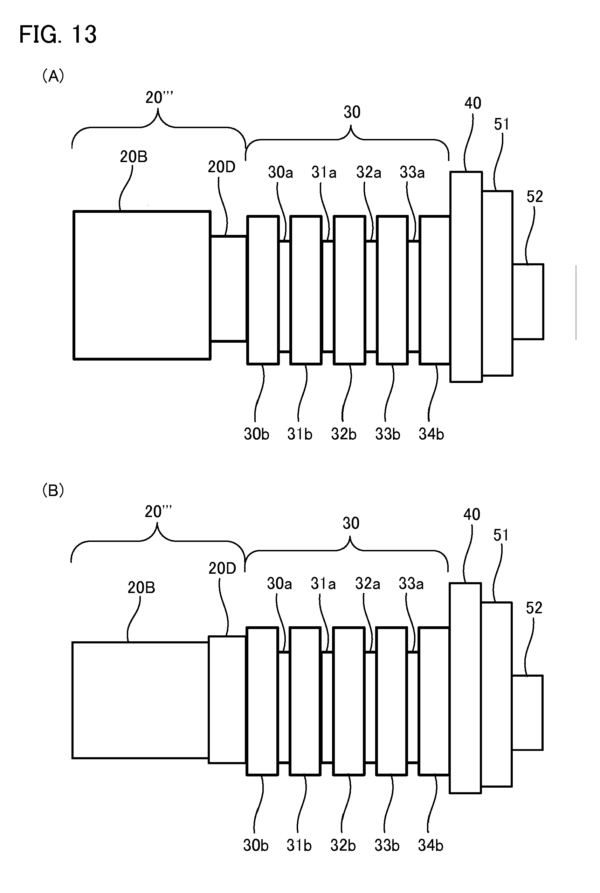

FIG. 12 is a schematic cross-sectional view of a nitride semiconductor light emitting device 500 of the present invention according to another embodiment. FIG. 13(A) and (B) is a view to explain examples of an energy band diagram of the nitride semiconductor light emitting device 500 of FIG. 12. In FIGS. 12 and 13, the same elements as FIGS. 1 to 11 are denoted by the same reference numerals as those in FIGS. 1 to 11, and description thereof is omitted. As depicted in FIG. 12, the nitride semiconductor light emitting device 500 has a n-type layer 20''' that consists of two layers of the n-type cladding layer 20B and an n-type current spreading layer 20D, instead of a single layer of the n-type layer 20, which is different from the nitride semiconductor light emitting devices 100 and 200 in FIGS. 1 and 6. As depicted in FIG. 12, the n-type current spreading layer 20D is arranged between the n-type cladding layer 20B and the active layer 30.

As to a semiconductor light emitting device necessary for current injection in the horizontal direction (in the direction of stacked planes in the stacked structure inside the device), generally, the distance required for carriers in the horizontal direction of the light emitting device is long enough compared to that in the depth direction of the light emitting device (in the direction of the normal line of the stacked planes in the stacked structure inside the device). Thus, drive voltage of the light emitting device increases as the resistance proportional to the distance required for carriers in the horizontal direction increases. Therefore, the structure of using a two dimensional electron gas is generally utilized in order to improve the carrier conductivity in the horizontal direction of the device. Such a structure is called a current spreading layer. In the n-type current spreading layer 20D, Fermi level is at an upper side than the bottom end of the conduction band due to formation of a triangular potential. The n-type cladding layer 20B is a layer that plays a role of supplying electrons to the active layer. It is preferable that these n-type cladding layer 20B and n-type current spreading layer 20D include, for example, Si as a dopant so that the impurity concentration is from $1\times10^{16}$ to $1\times10^{21}$ $(cm^{-3})$, in order to be made to be n-type layers. These impurities (dopant) may be distributed among the n-type cladding layer 20B and the n-type current spreading layer 20D either homogeneously or unhomogeneously.

FIG. 13(A) is a view to explain an energy band diagram in a case where the band gap of the n-type current spreading layer 20D is smaller than that of the n-type cladding layer 20B. In this case, a layer of the smallest energy gap in the n-type layer (first n-type layer) is the n-type current spreading layer 20D.

The n-type current spreading layer 20D may have a larger band gap than the n-type cladding layer 20B as long as a two dimensional electron gas can be generated due to the formation of a triangular potential. FIG. 13(B) is a view to explain an energy band diagram in a case where the band gap of the n-type current spreading layer 20D is larger than that of the n-type cladding layer 20B. In this case, a layer of the smallest energy gap in the n-type layer (first n-type layer) is the n-type cladding layer 20B.

It is not specifically limited but difference between the n-type cladding layer 20B and the n-type current spreading layer 20D in band gap is preferably no less than 0.03 eV and no more than 2.00 eV. In a case where the absolute value of the band gap of the n-type current spreading layer 20D is smaller than that of the n-type cladding layer 20B (see FIG. 13(A)), the absolute value of the band gap of the n-type current spreading layer 20D is preferably no less than 4.15 eV and no more than 6.27 eV, and the band gap of the n-type cladding layer 20B is preferably no less than 4.18 eV and no more than 6.30 eV. In a case where the absolute value of the band gap of the n-type current spreading layer 20D is larger than that of the n-type cladding layer 20B (see FIG. 13(B)), the absolute value of the band gap of the n-type current spreading layer 20D is preferably no less than 4.18 eV and no more than 6.30 eV, and the band gap of the n-type cladding layer 20B is preferably no less than 4.15 eV and no more than 6.27 eV.

The thickness of the n-type cladding layer 20B is preferably no less than 1 nm and no more than 50 $\mu$m. The thickness of the n-type current spreading layer 20D is preferably no less than 1 nm and no more than 1 $\mu$m.

Given as an example in the above description mainly is the nitride semiconductor light emitting device 500 that has the embodiment where the n-type current spreading layer 20D is arranged independently from the n-type cladding layer 20B, and the active layer 30 is stacked while contacting the n-type current spreading layer 20D. However, the present invention is not limited to this embodiment. The nitride semiconductor light emitting device can take such an embodiment that the n-type current spreading layer is composed inside the n-type cladding layer, and thus, the active layer is not in contact with the n-type current spreading layer directly.

While in the above description, mainly given as an example is the nitride semiconductor light emitting device 500 that has the embodiment of including the first p-type layer (p-type cladding layer) 51 and the second p-type layer (p-type contacting layer) 52 as the p-type layer, the present invention is not limited to this embodiment. The nitride semiconductor light emitting device can take such an embodiment that the third p-type layer is further arranged between the active layer and the electron blocking layer.

(Other Combination in n-type Layer)

The nitride semiconductor light emitting devices 300, 400 and 500 having the embodiment of including the n-type layer consisting of combination of two layers, are given as examples in the above description concerning the nitride semiconductor light emitting device of the present invention, which has the embodiment of including the n-type layer consisting of a plurality of layers. However, the present invention is not limited to the embodiment. The nitride semiconductor light emitting device can take an embodiment of including the n-type layer consisting of other combination of a plurality of layers. For example, a plurality of layers composing the n-type layer can be at least two layers selected from the n-type underlayer, the n-type cladding layer, the n-type hole blocking layer and the n-type current spreading layer. The thickness of each layer is as described above. The order of stacking the given plurality of layers composing the n-type layer on the substrate as an example is preferably the following (layers enclosed by parentheses mean that such layers are not always necessary. The stacked order of the n-type hole blocking layer and the n-type current spreading layer is not specifically limited):

substrate/(n-type underlayer)/n-type cladding layer/(n-type hole blocking layer, n-type current spreading layer)

In a case where the plurality of layers composing the n-type layer is such a combination, a layer having the smallest band gap among the n-type underlayer, n-type cladding layer, n-type hole blocking layer and n-type current spreading layer corresponds to the first n-type layer.

(Other Embodiments (4): Embodiment where p-type Layer is Single Layer)

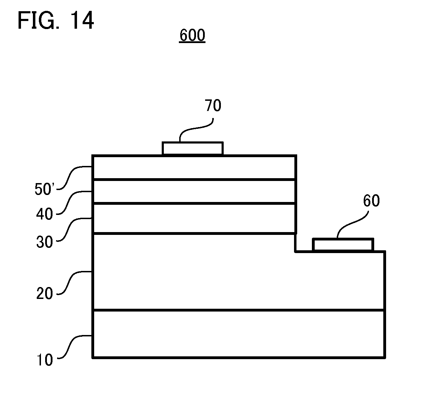

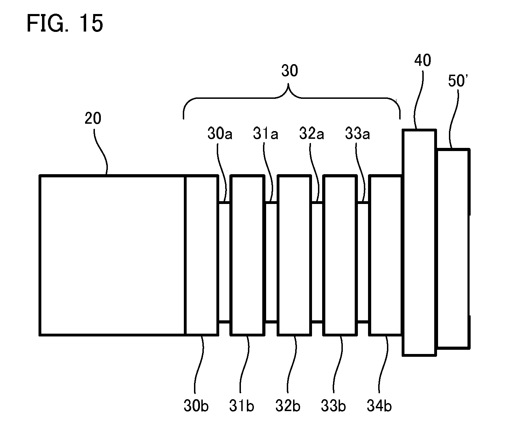

Mainly given as an example in the above description concerning the present invention are the nitride semiconductor light emitting devices 100, 100', 100", 100"', 200, 300, 400 and 500, which have the embodiment of having the p-type layer consisting of a plurality of layers of different band gaps. However, the present invention is not limited to the embodiment. The nitride semiconductor light emitting device can take an embodiment of the p-type layer of a single layer. FIG. 14 is a schematic cross-sectional view of a nitride semiconductor light emitting device 600 of the present invention according to such another embodiment. FIG. 15 is a view to explain one example of an energy band diagram of the nitride semiconductor light emitting device 600. In FIGS. 14 and 15, the same elements as those already depicted in FIGS. 1 to 13 are denoted by the same reference numerals as those in FIGS. 1 to 13, and description thereof is omitted. The nitride semiconductor light emitting device 600 has a p-type layer 50' that is a single layer, instead of the p-type layer 50, which consists of a plurality of layers, which is different from the above given nitride semiconductor light emitting device 100 and the like. In the nitride semiconductor light emitting device 600 as an example, the p-type layer 50' corresponds to the p-type layer having a band gap larger than that of the first n-type layer having the smallest band gap in the n-type layer, that is, the first p-type layer.

<2. Nitride Semiconductor Wafer>

The second aspect of the present invention is a nitride semiconductor wafer that has the stacked structures described above concerning the nitride semiconductor light emitting device of the present invention. In the nitride semiconductor wafer of the present invention, generally, the stacked structures of the nitride semiconductor light emitting device of the present invention described above is formed. A plurality of the nitride semiconductor light emitting devices of the present invention can be obtained by cutting each device out of the nitride semiconductor wafer.

Examples

The present invention will be described in detail with Examples and Comparison Examples hereinafter. The present invention is not limited to the following examples.

In the following Examples and Comparative Examples, the proportion of constituent elements of each layer was measured by X-ray diffraction (XRD), and band gaps were obtained by photo luminescence (PL). X'Pert PRO manufactured by PANalytical B. V. was used for the XRD measurement, and HR800 UV manufactured by HORIBA, Ltd. was used for the measurement by PL. SMS-500 manufactured by SphereOptics GmbH was used for the measurement of the emission wavelength, and the wavelength of the strongest emission intensity was recorded as the emission wavelength. The external quantum efficiency was measured with the same apparatus as used for the measurement of the emission wavelength.

<Example 1 and Comparison Examples 1 to 2>

(Example 1)

The nitride semiconductor light emitting device having a stacked structure depicted in FIG. 1 was manufactured.

First, an $Al_{0.75}Ga_{0.25}N$ layer where Si was doped (first n-type layer; band gap: 5.23eV, Si concentration: $1 \times 10^{19}$ $cm^{-3}$, and thickness: 1.0 $\mu$m) was formed on a c-plane of the AlN substrate 10, which was 7 by 7 mm square and 500 $\mu$m in thickness, by MOCVD as the n-type layer (20).

The active layer (30) having a quantum well structure that included four quantum wells (see FIG. 2) was formed over the n-type layer (20) by composing five barrier layers (composition: $Al_{0.75}Ga_{0.25}N$, band gap: 5.23 eV, undoped, and thickness: 7 nm) and four well layers (composition: $Al_{0.5}Ga_{0.5}N$, band gap: 4.55 eV, undoped, and thickness: 7 nm) so that the barrier layers and the well layers were stacked by turns. One of the barrier layers was formed so as to contact the n-type layer (20) and another barrier layer was formed as the outermost layer.

An AlN layer where Mg was doped (band gap: 6.00 eV, Mg concentration: $5 \times 10^{19}$ $cm^{-3}$, and thickness: 30 nm) was formed over the active layer (30) (that is, over the barrier layer that was the outermost layer of the active layer) as the electron blocking layer (40).

An $Al_{0.8}Ga_{0.2}N$ layer where Mg was doped (band gap: 5.38 eV; Mg concentration: $5 \times 10^{19}$ $cm^{-3}$, and thickness: 50 nm) was formed over the electron blocking layer (40) as the first p-type layer (p-type cladding layer) (51). A GaN layer where Mg was doped (band gap: 3.40 eV, Mg concentration: $2 \times 10^{19}$ $cm^{-3}$, and thickness 100 nm) was formed over the first p-type layer (p-type cladding layer) (51) as the second p-type layer (p-type contacting layer) (52).

Next, heat treatment was carried out in a nitrogen atmosphere for 20 minutes at 900C°. After that, a predetermined resist pattern was formed on the surface of the second p-type layer (p-type cladding layer) (52) by photolithography, and etching was carried out on a window that is a part where the resist patter was not formed by reactive ion etching until the surface of the n-type layer (20) was exposed. Then, a Ti(20 nm)/Al(200 nm)/Au(5 nm) electrode (anode) was formed on the surface of the n-type layer (20) by evaporation, and heat treatment was carried out in a nitrogen atmosphere for 1 minute at 810C°. Next, an Ni(20 nm)/Au(50 nm) electrode (cathode) was formed on the surface of the the second p-type layer (p-type contacting layer) (52) by evaporation, and after that, heat treatment was carried out in an oxygen atmosphere for 3 minutes at 550C°, to manufacture the nitride semiconductor light emitting device.

The obtained nitride semiconductor light emitting device had the emission wavelength of 267 nm when the current injection was 10 mA, and its external quantum efficiency was 2.2%.

(Comparative Example 1)

The nitride semiconductor light emitting device was manufactured with the same operation as Example 1 except that in Example 1, the first p-type layer (p-type cladding layer) (51) was changed to have the composition $Al_{0.75}Ga_{0.25}N$ and the band gap of 5.23 eV (Mg concentration: $5 \times 10^{19}$ cm$^{-3}$).

The obtained nitride semiconductor device had the emission wavelength of 267 nm when the current injection was 10 mA, and its external quantum efficiency was 1.7%.

(Comparative Example 2)

The nitride semiconductor light emitting device was manufactured with the same operation as Example 1 except that in Example 1, the first p-type layer (p-type cladding layer) 51 was changed to have the composition $Al_{0.7}Ga_{0.3}N$ and the band gap of 5.09 eV (Mg concentration: $5 \times 10^{19}$ cm$^{-3}$).

The obtained nitride semiconductor light emitting device had the emission wavelength of 267 nm when the current injection was 10 mA, and its external quantum efficiency was 1.3%.

<Examples 2 to 5>

(Example 2)

A wafer including a plurality of the nitride semiconductor light emitting devices of stacked structures depicted in FIG. 1 was manufactured, and nitride semiconductor light emitting devices were cut out from the wafer. It is noted that the number of quantum wells in each active layer was three.

First, an $Al_{0.75}Ga_{0.25}N$ layer of 1.0 $\mu$m in thickness where Si was doped (band gap: 5.23 eV, Si concentration: $1 \times 10^{19}$ cm$^{-3}$) was formed on a c-plane of the AlN substrate (10), which was 7 by 7 mm square and 500 $\mu$m in thickness, by MOCVD as the n-type layer (20).

The active layer (30) having a quantum well structure that included three quantum wells was formed over the n-type layer (20) by composing four barrier layers where Si was doped (composition: $Al_{0.75}Ga_{0.25}N$, band gap: 5.23 eV, Si concentration: $1 \times 10^{18}$ cm$^{-3}$, and thickness: 7 nm) and three well layers (composition: $Al_{0.5}Ga_{0.5}N$, band gap: 4.55 eV, undoped, and thickness: 2 nm) so that the barrier layers and the well layers were stacked by turns. One of the barrier layers was formed so as to contact the n-type layer (20) and another barrier layer was formed as the outermost layer.

An AlN layer where Mg was doped (band gap: 6.00 eV, Mg concentration: $5 \times 10^{19}$ cm$^{-3}$, and thickness: 15 nm) was formed over the active layer (30) (that is, over the barrier layer that was the outermost layer of the active layer) as the electron blocking layer (40).

An $Al_{0.80}Ga_{0.20}N$ layer where Mg was doped (band gap: 5.38 eV; Mg concentration: $5 \times 10^{19}$ cm$^{-3}$, and thickness: 50 nm) was formed over the electron blocking layer (40) as the first p-type layer (p-type cladding layer) (51). A GaN layer where Mg was doped (band gap: 3.40 eV, Mg concentration: $2 \times 10^{19}$ cm$^{-3}$, and thickness 100 nm) was formed over the first p-type layer (p-type cladding layer) (51) as the second p-type layer (p-type contacting layer) (52).

Next, heat treatment was carried out in a nitrogen atmosphere for 20 minutes at 900C°. After that, a predetermined resist pattern was formed on the surface of the second p-type layer (p-type contacting layer) (52) by photolithography, and etching was carried out on a window that is a part where the resist patter was not formed by reactive ion etching until the surface of the n-type layer (20) was exposed. Then, a Ti(20 nm)/Al(200 nm)/Au(5 nm) electrode (anode) was formed on the surface of the n-type layer (20) by evaporation, and heat treatment was carried out in a nitrogen atmosphere for 1 minute at 810C°. Next, anNi(20 nm)/Au(50 nm) electrode (cathode) was formed on the surface of the the second p-type layer (p-type contacting layer) (52) by evaporation, and after that, heat treatment was carried out in an oxygen atmosphere for 3 minutes at 550C°, to manufacture the nitride semiconductor wafer having the above stacked structure. The nitride semiconductor light emitting device was manufactured by cutting the obtained nitride semiconductor wafer into pieces 700 by 700 $\mu$m square.

The obtained nitride semiconductor device had the emission wavelength of 272 nm when the current injection was 100 mA, and its external quantum efficiency was 2.0%.

(Example 3)

The nitride semiconductor wafer and nitride semiconductor light emitting device were manufactured with the same operation as Example 2 except that in Example 2, each barrier layer was changed to have the composition $Al_{0.65}Ga_{0.35}N$ (band gap: 4.95 eV, Si concentration: $1 \times 10^{18}$ cm$^{-3}$). The obtained nitride semiconductor light emitting device had the emission wavelength of 267 nm when the current injection was 100 mA, and its external quantum efficiency was 2.3%.

(Example 4)

The nitride semiconductor wafer and nitride semiconductor light emitting device were manufactured with the same operation as Example 3 except that in Example 3, the thickness of each well layer was changed from 2 nm to 4 nm. The obtained nitride semiconductor light emitting device had the emission wavelength of 270 nm when the current injection was 100 mA, and its external quantum efficiency was 2.7%.

(Example 5)

The nitride semiconductor wafer and nitride semiconductor light emitting device were manufactured with the same operation as Example 3 except that in Example 2, each barrier layer was changed to have the composition $Al_{0.60}Ga_{0.40}N$ (band gap: 4.81 eV, Si concentration: $1 \times 10^{18}$ cm$^{-3}$) and the thickness of each well layer was changed from 2 nm to 6 nm. The obtained nitride semiconductor light emitting device had the emission wavelength of 263 nm when the current injection was 100 mA, and its external quantum efficiency was 3.2%.

<Evaluation Result>

The compositions and evaluation results of Examples 1 to 5 and Comparative Examples 1 to 2 are represented in Table 1.

[Table 1]

| | | | Example 1 | Comparative Example 1 | Comparative Example 2 | Example 2 | Example 3 | Example 4 | Example 5 |
|---|---|---|---|---|---|---|---|---|---|
| n-type Layer | | Composition: $Al_dGa_{1-d}N$ | d = 0.75 | | | | | | |
| | | Band Gap (eV) | 5.23 | | | | | | |
| | | Doping | si, $1\times10^{19}$ cm$^{-3}$ | | | | | | |
| | | Thickness (nm) | 1000 | | | | | | |
| Active Layer | Barrier Layer | Composition: $Al_aGa_{1-a}N$ | a = 0.75 | | | | a = 0.65 | | a = 0.60 |
| | | Band Gap (eV) | 5.23 | | | | 4.95 | | 4.81 |
| | | Doping | Undoped | | | Si, $1\times10^{18}$ cm$^{-3}$ | | | |
| | | Thickness (nm) | 7 | | | | | | |
| | Well Layer | Composition: $Al_eGa_{1-e}N$ | e = 0.50 | | | | | | |
| | | Band Gap (eV) | 4.55 | | | | | | |
| | | Doping | Undoped | | | | | | |
| | | Thickness (nm) | 2 | | | | | 4 | 6 |
| the Number of Quantum Wells in Active Layer | | | 4 | | | 3 | | | |
| Electron Blocking Layer | | Composition: $Al_cGa_{1-c}N$ | c = 1.00 | | | | | | |
| | | Band Gap (eV) | 6.00 | | | | | | |
| | | Doping | Mg, $5\times10^{19}$ cm$^{-3}$ | | | | | | |
| | | Thickness (nm) | 30 | | | 15 | | | |

EP 2 955 763 A1

(continued)

| | | | Example 1 | Comparative Example 1 | Comparative Example 2 | Example 2 | Example 3 | Example 4 | Example 5 |
|---|---|---|---|---|---|---|---|---|---|
| p-type Layer | First p-type Layer (p-type Cladding Layer) | Composition: $Al_bGa_{1-b}N$ | b = 0.75 | b = 0.70 | b = 0.80 | | | | |
| | | Band Gap (eV) | 5.23 | 5.09 | 5.38 | | | | |
| | | Doping | Mg, $5\times10^{19}$ cm$^{-3}$ | | | | | | |
| | | Thickness (nm) | 50 | | | | | | |
| | Second p-type Layer (p-type Contacting Layer) | Composition: $Al_fGa_{1-f}N$ | f = 0.00 | | | | | | |
| | | Band Gap (eV) | 3.40 | | | | | | |
| | | Doping | Mg, $2\times10^{19}$cm$^{-3}$ | | | | | | |
| | | Thickness (nm) | 100 | | | | | | |
| b-a | | | 0.00 | -0.05 | 0.05 | 0.05 | 0.15 | 0.15 | 0.20 |
| a-e | | | 0.25 | 0.25 | 0.25 | 0.25 | 0.15 | 0.15 | 0.10 |
| c-a | | | 0.25 | 0.25 | 0.25 | 0.25 | 0.35 | 0.35 | 0.40 |
| Injection Current (mA) | | | 10 | | | 100 | | | |
| Emission Wavelength (nm) | | | 267 | 267 | 267 | 272 | 267 | 270 | 263 |
| External Quantum Efficiency (%) | | | 2.2 | 1.7 | 1.3 | 2.0 | 2.3 | 2.7 | 3.2 |

The nitride semiconductor devices of Examples 1 to 5 presented good light emission efficiency compared with the nitride semiconductor light emitting device of Comparative Examples 1 to 2, where the p-type layer of a larger band gap than the smallest band gap in the n-type layer was not included in the side of the electron blocking layer opposite to the active layer. Every nitride semiconductor devices of Examples 1 to 5 had a stacked structure where the n-type layer, the active layer having the well layer and the barrier layer, the electron blocking layer, the first p-type layer (p-type cladding layer) and the second p-type layer (p-type contacting layer) were stacked in this order, the barrier layer was represented by the composition formula $Al_aGa_{1-a}N$ ($0.34 \leq a \leq 0.89$), and the first p-type layer (p-type cladding layer) was represented by the composition formula $Al_bGa_{1-b}N$ ($0.44 < b < 1.00$). Among them, the nitride semiconductor light emitting devices of Examples 3 to 5 where the difference between the Al composition of the first p-type layer (p-type cladding layer) and that of each barrier layer (b-a) was over 0.10 and no more than 0.45 presented the light emission efficiency superior to the nitride semiconductor light emitting devices of Examples 1 to 2, where the difference was not as the above. Moreover, the nitride semiconductor light emitting devices of Examples 4 to 5, where the thickness of each well layer was in the range of 4 to 20 nm presented an specifically superior light emission efficiency.

Reference Signs List

    10 substrate
    20, 20', 20", 20''' n-type layer
    20A n-type underlayer
    20B n-type cladding layer
    20C n-type hole blocking layer
    20D n-type current spreading layer
    30 active layer (active layer region)
    30a, 31a, 32a, 33a well layer
    30b, 31b, 32b, 33b, 34b barrier layer
    40 electron blocking layer
    50, 50' p-type layer
    51 first p-type layer (p-type cladding layer)
    52 second p-type layer (p-type contacting layer)
    53 third p-type layer
    60 electrode for n-type
    70 electrode for p-type
    100, 100', 100", 100''', 200, 300, 400, 500, 600 nitride semiconductor light emitting device (deep ultraviolet semiconductor light emitting device)

**Claims**

1. A nitride semiconductor light emitting device having emission wavelength of 200 to 300 nm, comprising:

    an n-type layer consisting of a single layer or a plurality of layers having different band gaps;
    a p-type layer consisting of a single layer or a plurality of layers having different band gaps;
    an active layer arranged between the n-type layer and the p-type layer; and
    an electron blocking layer having a band gap larger than any band gap of layers composing the active layer and the p-type layer,
    wherein the p-type layer comprises a first p-type layer having a band gap larger than a band gap of a first n-type layer which has a smallest band gap in the n-type layer; and
    the electron blocking layer is arranged between the active layer and the first p-type layer.

2. The nitride semiconductor light emitting device according to claim 1,
    wherein the p-type layer consists of the plurality of layers having different band gaps.

3. The nitride semiconductor light emitting device according to claim 1 or 2,
    wherein the active layer comprises a well layer and a barrier layer;
    the p-type layer comprises a p-type cladding layer and a p-type contacting layer;
    the nitride semiconductor light emitting device comprises a stacked structure in which the n-type layer, the active layer, the electron blocking layer, the p-type cladding layer, and the p-type contacting layer are stacked in the order mentioned;

the barrier layer is represented by a composition formula $Al_aGa_{1-a}N$ ($0.34 \leq a \leq 0.89$);

the p-type cladding layer is represented by a composition formula $Al_bGa_{1-b}N$ ($0.44 < b < 1.00$); and

a difference (b-a) between the Al composition of the p-type cladding layer and the Al composition of the barrier layer is greater than 0.10 and no more than 0.45.

**4.** The nitride semiconductor light emitting device according to claim 3,

wherein the well layer is represented by a composition formula $Al_eGa_{1-e}N$ ($0.33 \leq e \leq 0.87$); and

a difference (a-e) between the Al composition of the barrier layer and the Al composition of the well layer is no less than 0.02.

**5.** The nitride semiconductor light emitting device according to claim 3 or 4,

wherein the well layer has a thickness of 4 to 20 nm.

**6.** The nitride semiconductor light emitting device according to any one of claims 3 to 5,

wherein the electron blocking layer is p-type or i-type;

the electron blocking layer is represented by a composition formula $Al_cGa_{1-c}N$ ($0.45 \leq c \leq 1.00$);

the p-type cladding layer is represented by a composition formula $Al_bGa_{1-b}N$ ($0.44 < b < 1.00$);

the Al composition (c) of the electron blocking layer is greater than the Al composition (b) of the p-type cladding layer;

a difference (c-a) between the Al composition of the electron blocking layer and the Al composition of the barrier layer is 0.11 to 0.98; and

a difference (b-a) between the Al composition of the p-type cladding layer and the Al composition of the barrier layer is greater than 0.10 and no more than 0.45.

**7.** The nitride semiconductor light emitting device according to any one of claims 3 to 6,

wherein the nitride semiconductor light emitting device comprises a plurality of the barrier layers; and

the plurality of barrier layers comprises:

a first barrier layer contacting the n-type layer; and
a second barrier layer contacting the electron blocking layer.

**8.** A nitride semiconductor wafer comprising stacked structures of the nitride semiconductor light emitting device as in any one of claims 1 to 7.

100

FIG. 1

FIG. 2

FIG. 3

100'

FIG. 4

100''

FIG. 5

100'''

30'''

40

51

52

20

30a  31a  32a  33a

31b  32b  33b  34b

FIG. 6

FIG. 7

300

FIG. 8

FIG. 9

(A)

(B)

FIG. 10

400

70

50 { 52
      51
40
30
20'' { 20C
        20B
10

60

FIG. 11

FIG. 12

500

70

50 { 52
51

40

30

20''' { 20D
20B

10

60

FIG. 13

(A)

(B)

FIG. 14

600

FIG. 15

## INTERNATIONAL SEARCH REPORT

| International application No. |
| --- |
| PCT/JP2014/052474 |

**A. CLASSIFICATION OF SUBJECT MATTER**
*H01L33/32*(2010.01)i, *H01S5/343*(2006.01)i

According to International Patent Classification (IPC) or to both national classification and IPC

**B. FIELDS SEARCHED**

Minimum documentation searched (classification system followed by classification symbols)
H01L33/00-33/64, H01S5/00-5/50

Documentation searched other than minimum documentation to the extent that such documents are included in the fields searched

| | | | |
| --- | --- | --- | --- |
| Jitsuyo Shinan Koho | 1922–1996 | Jitsuyo Shinan Toroku Koho | 1996–2014 |
| Kokai Jitsuyo Shinan Koho | 1971–2014 | Toroku Jitsuyo Shinan Koho | 1994–2014 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2007-88270 A (Matsushita Electric Works, Ltd.), 05 April 2007 (05.04.2007), entire text; all drawings (Family: none) | 1-8 |
| A | JP 2010-205767 A (Riken, Japan), 16 September 2010 (16.09.2010), entire text; all drawings & US 2010/0219395 A1 | 1-8 |
| A | JP 2013-16711 A (Panasonic Corp.), 24 January 2013 (24.01.2013), entire text; all drawings & WO 2013/005789 A1 | 1-8 |

|☒ Further documents are listed in the continuation of Box C. | ☐ See patent family annex. |
| --- | --- |

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 20 February, 2014 (20.02.14) | 04 March, 2014 (04.03.14) |

| Name and mailing address of the ISA/ Japanese Patent Office | Authorized officer |
| --- | --- |
| Facsimile No. | Telephone No. |

Form PCT/ISA/210 (second sheet) (July 2009)

**INTERNATIONAL SEARCH REPORT**

| International application No. |
|---|
| PCT/JP2014/052474 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2005-93895 A  (Sumitomo Electric Industries, Ltd.), 07 April 2005 (07.04.2005), entire text; all drawings & US 2005/0062054 A1    & EP 1517379 A2 & NO 20041523 A         & TW 232599 B & KR 10-2005-0029103 A   & CN 1599086 A | 1-8 |
| A | JP 2012-18963 A  (Sony Corp.), 26 January 2012 (26.01.2012), entire text; all drawings & US 2012/0008657 A1    & CN 102315589 A | 1-8 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007088269 A
- JP 2010205767 A
- JP H11298090 A

**Non-patent literature cited in the description**

- *J.Appl.Phys.,* 2010, vol. 108, 033112
- *Electorn.Lett.,* 2008, vol. 44, 493